# EUROPÄISCHE PATENTANMELDUNG

(11) **EP 4 486 060 A1**
(43) Veröffentlichungstag der Anmeldung: **01.01.2025**
(21) Anmeldenummer: 24181896.2
(22) Anmeldetag: 13.06.2024
(51) Int. Cl.: H05B 6/12

(54) **LEISTUNGSTEIL UND INDUKTIONSKOCHFELD MIT EINEM SOLCHEN LEISTUNGSTEIL**

(30) Priorität: 30.06.2023 DE 102023117291
(71) Anmelder: E.G.O. Elektro-Gerätebau GmbH, 75038 Oberderdingen (DE)
(72) Erfinder: Parker, Daniel, 75203 Königsbach-Stein (DE); Richter, Andreas, 74211 Leingarten (DE)
(74) Vertreter: Patentanwälte Ruff, Wilhelm, Beier, Dauster & Partner mbB

(57) **Zusammenfassung**

Ein Leistungsteil für ein Induktionskochfeld weist einen Bauteilträger auf, auf dem zu kühlende Bauteile und eine Kühlkörpereinrichtung dafür angeordnet sind, einen Lüfter in Richtung zu der Kühlkörpereinrichtung und einen Luftkanal von dem Lüfter zu der Kühlkörpereinrichtung. Die Kühlkörpereinrichtung ist länglich und begrenzt den Luftkanal teilweise, wobei dieser zwei oder drei äußere Wandungen aufweist und dadurch gebildet wird, die aneinander angrenzen und winklig zueinander angeordnet sind. Der Luftkanal erstreckt sich entlang dieser Wandungen an der Kühlkörpereinrichtung entlang, wobei er an einem Anfangsbereich der Kühlkörpereinrichtung einen Freibereich außerhalb der Kühlkörpereinrichtung und zwischen den äußeren Wandungen aufweist. Dieser Freibereich wird in Längsrichtung des Luftkanals weg von dem Lüfter hin zu einem Ende des Luftkanals kleiner, wobei er bis zu dem Ende des Luftkanals hin zu Null wird. So kann in dem Freibereich entlang strömende Luft auch weiter hinten im Luftkanal in einen Kühlkörper eingeleitet werden.

## Beschreibung

### Anwendungsgebiet und Stand der Technik

Die Erfindung betrifft ein Leistungsteil, wie es insbesondere für ein Elektrogerät wie beispielsweise ein Induktionskochfeld mit einem Umrichter verwendet wird. Des Weiteren betrifft die Erfindung ein solches Induktionskochfeld mit einem entsprechenden Leistungsteil. Das Leistungsteil weist einen Bauteilträger mit zu kühlenden Bauteilen darauf auf, insbesondere Leistungshalbleiter bzw. IGBT für einen Umrichter bzw. für einen Wechselrichter. Des Weiteren weist das Leistungsteil eine Kühlkörpereinrichtung mit mindestens einem Kühlkörper auf, an dem die zu kühlenden Bauteile anliegen. Ein Lüfter kühlt wiederum die Kühlkörpereinrichtung, wofür Luft in einem Luftkanal an der Kühlkörpereinrichtung entlangströmt.

Eine mögliche Anordnung eines solchen Leistungsteils mit Kühlkörper und Lüfter ist aus der CN 102769952 A1 bekannt. Hier bläst der Lüfter die ausgestoßene Luft direkt auf den Kühlkörper, um diesen zu kühlen. Dabei ist der Lüfter sogar direkt auf dem Kühlkörper angebracht.

Aus der FR 2340513 A1 ist ein Induktionskochfeld bekannt mit einer Kühlluftführung. Diese soll zusätzlich noch einen Kamineffekt nutzen.

### Aufgabe und Lösung

Der Erfindung liegt die Aufgabe zugrunde, ein eingangs genanntes Leistungsteil sowie ein damit versehenes Induktionskochfeld zu schaffen, mit denen Probleme des Standes der Technik gelöst werden können und es insbesondere möglich ist, das Leistungsteil kompakt und einfach aufzubauen bei gleichzeitig möglichst guter Kühlung der Kühlkörpereinrichtung bzw. der daran zu kühlenden Bauteile.

Gelöst wird diese Aufgabe durch ein Leistungsteil mit den Merkmalen des Anspruchs 1 sowie durch ein Induktionskochfeld mit den Merkmalen des Anspruchs 15. Vorteilhafte sowie bevorzugte Ausgestaltungen der Erfindung sind Gegenstand der weiteren Ansprüche und werden im Folgenden näher erläutert. Dabei werden manche Merkmale nur für das Leistungsteil oder nur für das Induktionskochfeld beschrieben. Sie sollen jedoch unabhängig davon sowohl für ein Leistungsteil als auch für ein damit versehenes Induktionskochfeld selbständig und unabhängig voneinander gelten können. Der Wortlaut der Ansprüche wird durch ausdrückliche Bezugnahme zum Inhalt der Beschreibung gemacht.

Das Leistungsteil weist also einen Bauteilträger auf, auf dem zu kühlende Bauteile angeordnet sind, insbesondere sind dies vorgenannte Leistungshalbleiter, beispielsweise für einen Umrichter bzw. Wechselrichter. Das Leistungsteil weist auch eine Kühlkörpereinrichtung auf, die mindestens einen einzelnen Kühlkörper aufweist. An der Kühlkörpereinrichtung liegen die genannten zu kühlenden Bauteile zur Wärmeübertragung bzw. zu ihrer Kühlung an. Eine solche Kühlkörpereinrichtung besteht vorteilhaft aus gut wärmeleitendem Material, besonders vorteilhaft aus Aluminium, insbesondere als Strangpressprofil. Das Leistungsteil weist einen Lüfter mit einem Lüfterauslass auf, wobei dieser Lüfterauslass zumindest in etwa in Richtung auf die Kühlkörpereinrichtung gerichtet ist. Die davon bewegte Kühlluft soll die Kühlkörpereinrichtung möglichst kühlen und die dabei erwärmte Luft aus dem Leistungsteil samt der aufgenommenen Wärme ausbringen. Für diese Luft ist ein Luftkanal vorgesehen, der von dem Lüfter bzw. von dessen Lüfterauslass weg führt und vor allem hin zu der Kühlkörpereinrichtung führt. So soll eine gezielte Führung von Luft erreicht werden, damit die Kühlwirkung für die Kühlkörpereinrichtung maximal wird.

Die Kühlkörpereinrichtung ist länglich, wobei sie insbesondere entlang einer Linie verlaufen kann bzw. entlang dieser Linie länglich ist, wobei diese Linie von der Längsachse oder parallel zu der Längsachse der Kühlkörpereinrichtung zu dem Lüfter bzw. dessen Lüfterauslass weist. Bevorzugt ist also der Lüfter mit seinem Lüfterauslass auf die Kühlkörpereinrichtung gerichtet. Dies kann durch den Luftkanal noch verbessert bzw. verstärkt werden, wobei der Luftkanal zumindest teilweise durch die Kühlkörpereinrichtung begrenzt ist. So kann auch sichergestellt sein, dass die in dem Luftkanal entlangströmende Luft die Kühlkörpereinrichtung kühlt. Der Luftkanal weist zwei oder drei äußere Wandungen auf, die aneinander angrenzen und winklig zueinander angeordnet sind. Vorteilhaft sind diese Wandungen flächig bzw. als Flächenteile ausgebildet. Besonders vorteilhaft treffen sie in etwa in einem rechten Winkel aufeinander bzw. stehen rechtwinklig oder in einem Winkel zwischen 70° und 90° zueinander. Dies können verschiedene äußere Wandungen sein, wie nachfolgend noch im Detail näher erläutert werden wird. Sie können auch gemeinsam zu einem Gehäuse gehören, insbesondere einteilig und einstückig miteinander verbunden sein. Der Luftkanal erstreckt sich also entlang dieser zwei oder drei äußeren Wandungen, und zwar an der Kühlkörpereinrichtung entlang, wobei er teilweise auch in der Kühlkörpereinrichtung entlang verläuft. Dies ist also die Erstreckung des Luftkanals zwischen den Wandungen und der Kühlkörpereinrichtung.

Erfindungsgemäß wird der Luftkanal im Wesentlichen von den genannten zwei oder drei äußeren Wandungen und von der Kühlkörpereinrichtung gebildet bzw. nach außen begrenzt. Dabei sollte der Luftkanal zumindest teilweise geschlossen sein, um ausreichend gut Luft dorthin leiten zu können, wo sie gewünscht ist bzw. benötigt wird. Der Luftkanal weist an seinem Anfangsbereich bzw. an einem Anfangsbereich der Kühlkörpereinrichtung einen Freibereich auf, der außerhalb der Kühlkörpereinrichtung liegt, aber noch innerhalb der genannten äußeren Wandungen, bzw. der Freibereich ist zwischen der Kühlkörpereinrichtung und den genannten äußeren Wandungen gebildet. Er liegt also sozusagen außerhalb der Kühlkörpereinrichtung, vorteilhaft aber in einem Bereich, in dem ein wesentlicher Teil der Luft vom Lüfter, der entlang des Luftkanals strömt, innerhalb der Kühlkörpereinrichtung strömt. Dieser Freibereich kann zwischen 5% und 50% des gesamten Luftkanals einnehmen, vorzugsweise zwischen 10% und 30%. Der Freibereich wird in Längsrichtung des Luftkanals weg von dem Lüfter und hin in Richtung zu einem Ende des Luftkanals kleiner. Dies kann kontinuierlich, stetig oder streng monoton stetig erfolgen. Zu Beginn des Luftkanals, also knapp hinter dem Luftauslass des Lüfters, ist der Freibereich am größten. Am Ende des Luftkanals, vorzugsweise wenn auch die Kühlkörpereinrichtung endet, ist der Freibereich am kleinsten, insbesondere ist er hier zu null geworden bzw. nicht mehr vorhanden.

Durch diesen Freibereich entlang des Luftkanals ist es möglich, dass ein Teil der Kühlluft, die den Lüfter am Luftauslass verlässt, nicht von Beginn an entlang bzw. in der Kühlkörpereinrichtung strömt und von dieser sowohl verlangsamt wird als auch vor allem aufgewärmt wird. Vielmehr kann ein Teil der von dem Lüfter erzeugten Luft in diesem Freibereich teilweise oder weitgehend an der Kühlkörpereinrichtung vorbei und somit von dieser nicht beheizt strömen. Erst später wieder, nämlich dort, wo der Freibereich kleiner wird, wird er wieder in die Kühlkörpereinrichtung eintreten oder hineinströmen. Somit kann in diesen Bereichen, insbesondere in einem vom Lüfter aus gesehen hinteren Bereich der Kühlkörpereinrichtung, sozusagen noch einmal kühlere Luft eintreten, damit auch dort eine gute und effiziente Kühlung der dort vorhandenen Bauteile möglich ist. Ansonsten würde nämlich in demjenigen Bereich der Kühlkörpereinrichtung, der am weitesten weg ist von dem Lüfter, hauptsächlich oder nur noch bereits aufgewärmte oder möglicherweise sogar heiße Luft ankommen. Diese aufgewärmte Luft könnte den hinteren Teil der Kühlkörpereinrichtung dann deutlich weniger kühlen, so dass auch die hier an der Kühlkörpereinrichtung anliegenden Bauteile weniger gekühlt werden können. Andere mögliche Lösungen für dieses Problem wie beispielsweise die Verwendung eines weiteren zusätzlichen Lüfters, der in weiter hinten gelegenen Bereichen noch einmal Luft zur Kühlung einbringt, können dann entfallen. Durch eine vielfältig mögliche Ausgestaltung des Luftkanals sowie vor allem des Freibereichs bzw. der Verengungen des Luftkanals bzw. des Freibereichs kann eine bessere und gezieltere Luftführung erreicht werden.

In möglicher Ausgestaltung der Erfindung kann ein Luftkanal gebildet sein von der Kühlkörpereinrichtung, von einem Gehäuseteil unter der Kühlkörpereinrichtung und von einer Außenwandung, die senkrecht bzw. winklig, insbesondere wie vorgenannt, zu dem Gehäuseteil steht. Vorzugsweise kann sie Teil desselben Gehäuses wie das Gehäuseteil sein. Entlang dieser Außenwandung ist der Freibereich zumindest teilweise gebildet. Es kann vorgesehen sein, dass der Luftkanal auch nach oben, also auf der dem Gehäuseteil gegenüberliegenden Seite des Luftkanals, geschlossen ist durch eine Abdeckung, die über der Kühlkörpereinrichtung, vorteilhaft über dem gesamten Leistungsteil, verläuft. Dies wären die vorgenannten drei äußeren Wandungen, die zusätzlich mit der Kühlkörpereinrichtung den Luftkanal bilden. Der Freibereich kann über die gesamte Höhe des Luftkanals gehen bzw. in vertikaler Richtung gleichbleibenden Querschnitt aufweisen und somit voll an der Außenwandung entlang verlaufen.

In einer ersten grundsätzlichen Weiterbildung der Erfindung kann die Kühlkörpereinrichtung derart ausgebildet sein, dass sie selbst entlang des Luftkanals keine Querschnittsänderung aufweist bzw. dass sie denselben, also konstanten, Querschnitt behält. Dann weist die Kühlkörpereinrichtung also keine Variation ihres Querschnitts auf bzw. wird weder breiter noch höher. Allerdings können in einer Ausbildung der Erfindung Einschnitte oder Unterbrechungen in der Kühlkörpereinrichtung vorgesehen sein, die in Richtung quer zur Längsrichtung der Kühlkörpereinrichtung vorgesehen sind. Dies wird allerdings nicht als Querschnittsänderung angesehen, da vor einem solchen Einschnitt oder einer solchen Unterbrechung und dahinter die Kühlkörpereinrichtung jeweils denselben Querschnitt aufweist. Derartige Einschnitte oder Unterbrechungen können ganz allgemein zum leichteren Einleiten von Luft in die Kühlkörpereinrichtung hinein oder zum Ausleiten von Luft aus dieser heraus dienen.

Bei dieser Weiterbildung der Erfindung verengt sich der Querschnitt des Luftkanals durch eine Änderung des Verlaufs mindestens einer der äußeren Wandungen entlang des Luftkanals selbst. Dadurch wird der Freibereich enger bzw. kleiner. Dies kann insbesondere dadurch vorgesehen sein, dass sich der Verlauf mindestens einer äußeren Wandung ändert. Bevorzugt kann dies eine vorgenannte Außenwandung sein, die der Kühlkörpereinrichtung gegenüberliegend am Luftkanal vorgesehen ist bzw. diesen nach außen begrenzt. An dieser Querschnittsänderung bzw. Verengung wird dann ein Teil der vom Lüfter ausgestoßenen Luft, die außerhalb der Kühlkörpereinrichtung entlang des Luftkanals strömt, sozusagen in die Kühlkörpereinrichtung gedrückt oder umgelenkt und sorgt dann für erhöhte Kühlung.

In möglicher Ausgestaltung der Erfindung können zwei oder drei solcher Querschnittsänderungen bzw. Verengungen des Freibereichs des Luftkanals vorgesehen sein. Hinter der letzten Querschnittsänderung bzw. Verengung kann der Luftkanal zu mindestens 90%, insbesondere vollständig oder im Wesentlichen vollständig, von dem Querschnitt der Kühlkörpereinrichtung eingenommen sein. Dies bedeutet, dass Luft nur noch in der Kühlkörpereinrichtung bzw. durch die Kühlkörpereinrichtung strömt. Die Kühlkörpereinrichtung reicht dann direkt bis an die vorgenannte Außenwandung oder zumindest bis wenige Millimeter davor.

Es kann vorgesehen sein, dass eine erste Verengung oder Querschnittsänderung des Luftkanals nach etwa 20% bis 45% der Länge des Luftkanals weg von dem Lüfter vorgesehen bzw. angeordnet ist. Somit kann ab diesem Bereich zum ersten Mal erneut sozusagen noch kalte Luft in die Kühlkörpereinrichtung eingeleitet werden. In weiterer Ausgestaltung der Erfindung kann vorgesehen sein, dass eine letzte Verengung des Luftkanals nach 70% bis 90% seiner Länge weg von dem Lüfter vorgesehen ist. Somit kann durch die dort eingeleitete kühlere Luft auch der letzte bzw. hinterste Bereich der Kühlkörpereinrichtung noch einmal verstärkt gekühlt werden. Eine Einleitung nochmals danach würde nicht mehr viel Sinn machen.

Es kann vorgesehen sein, dass jede Querschnittsänderung bzw. Verengung des Luftkanals den Freibereich um 25% bis 50% reduziert. So können vorteilhaft, aber nicht zwingend ausschließlich, zwei bis vier solcher Querschnittsänderungen bzw. Verengungen des Luftkanals vorgesehen sein, damit an entsprechend vielen Stellen noch einmal kalte Luft in die Kühlkörpereinrichtung umgelenkt wird.

Die vorgenannten Einschnitte oder Unterbrechungen sind hierfür zwar nicht zwingend nötig oder besonders vorteilhaft. Sie können das Einleiten von Kühlluft aber schon erleichtern bzw. verbessern. Des Weiteren können sie durch die Bildung zusätzlicher Wirbel für eine turbulentere Luftströmung sorgen und somit für einen besseren Wärmeaustausch. Insbesondere können derartige Einschnitte oder Unterbrechungen an einer sogenannten Basis der Kühlkörpereinrichtung vorgesehen sein, an welcher im Wesentlichen die vorgenannten zu kühlenden Bauteile anliegen. Eine derartige Basis ist bevorzugt massiv ausgebildet, da hier durch die zu kühlenden Bauteile maximal viel Wärmeenergie eingebracht wird und erst einmal sozusagen zur Seite hin in die übrige Kühlkörpereinrichtung, die vorteilhaft von Rippen gebildet wird, die von der Basis abstehen, hinein verteilt wird. Da diese Basis üblicherweise im Wesentlichen geschlossen ist, kann gerade hier durch die Einschnitte oder Unterbrechungen eine gute Möglichkeit geschaffen werden, Luft in diesem Bereich aus der Kühlkörpereinrichtung herauszuleiten. Dies kann den Sinn haben, dass diese Luft dann an nochmals weitere Bereiche oder Bauteile auf dem Bauteilträger geleitet wird, die auch gekühlt werden sollen, die aber außerhalb des genannten Luftkanals liegen.

In einer zweiten grundsätzlichen Weiterbildung der Erfindung kann der Querschnitt des gesamten Luftkanals gleich bleiben, hier ändert sich der Querschnitt der Kühlkörpereinrichtung und nicht der Verlauf der Wandungen außerhalb davon wie bei der zuvor beschriebenen ersten Weiterbildung der Erfindung. So kann die Kühlkörpereinrichtung an einem zu dem Lüfter weisenden oder diesem am nächsten gelegenen Anfangsbereich schmäler ausgebildet sein und einen verringerten Querschnitt aufweisen als weiter weg davon. Insbesondere kann der Querschnitt um 10% bis 50% verringert sein. Insbesondere kann vorgesehen sein, dass etwa 10% bis 30% der Länge der Kühlkörpereinrichtung den geringeren Querschnitt am Anfangsbereich aufweisen. Durch den dann größer werdenden Querschnitt wird der Freibereich des Luftkanals zu den äußeren Wandungen hin reduziert bzw. geringer, und so kann der zuvor beschriebene Effekt der im Längsverlauf des Luftkanals noch in die Kühlkörpereinrichtung hineingedrückten kühleren Luft erreicht werden. Allerdings wird dies dann eben nicht durch Änderung des Verlaufs der äußeren Wandungen erreicht, sondern durch Änderung des Verlaufs der Kühlkörpereinrichtung selbst. Dabei kann entweder der Querschnitt der Kühlkörpereinrichtung in Richtung weg von dem Lüfter entlang des Luftkanals zunehmen. Alternativ kann eine Kühlkörpereinrichtung mit gleichbleibendem Querschnitt sozusagen leicht schräg zur eigentlichen Längsrichtung des Luftkanals und auch schräg zu einer der Kühlkörpereinrichtung gegenüberliegenden Wandung des Luftkanals ausgerichtet sein. So verengen sich dieser Luftkanal kontinuierlich und damit auch der Freibereich, wodurch bis zum Ende des Luftkanals sämtliche Luft in die Kühlkörpereinrichtung hinein umgelenkt worden ist. Durch eine Ausbildung der äußeren Wandungen des Luftkanals in gerader Form kann eine besonders einfache Ausgestaltung des Luftkanals erreicht werden.

In weiterer Ausgestaltung der Erfindung kann vorgesehen sein, dass entweder die Kühlkörpereinrichtung mehrere Teil-Kühlkörper mit gleichem oder identischem Querschnitt aufweist, wobei diese Teil-Kühlkörper hintereinander in der Längsrichtung des Luftkanals angeordnet sind. Dies kann also eine sozusagen stärkere Ausgestaltung der vorgenannten Variation sein, dass Einschnitte oder Unterbrechungen in der Kühlkörpereinrichtung vorgesehen sind. Zwischen mindestens zwei solcher Teil-Kühlkörper, insbesondere zwischen allen Teil-Kühlkörpern, kann ein Abstand vorgesehen sein, um einen Zwischenbereich zu bilden. In diesem Zwischenbereich ist dann kein Kühlkörper vorgesehen. Ein solcher Zwischenbereich kann eine Länge zwischen 1% und 10% der Länge der gesamten Kühlkörpereinrichtung aufweisen, so dass diese Zwischenbereiche bzw. Abstände zwischen zwei aufeinanderfolgenden Teil-Kühlkörpern relativ gering sind. In möglicher weiterer Ausgestaltung der Erfindung können zumindest zwei Teil-Kühlkörper unterschiedliche Länge entlang der Längsrichtung des Luftkanals aufweisen. So können vorzugsweise Teil-Kühlkörper näher zu dem Lüfter hin länger ausgebildet sein als Teil-Kühlkörper mit mehr Abstand. An den längeren Teil-Kühlkörpern können dann auch diejenigen Bauteile angeordnet sein, die im normalen oder üblichen bzw. häufigsten Betrieb am heißesten werden. Ihnen können dann also die größeren Teil-Kühlkörper zur Verfügung stehen.

In alternativer Ausgestaltung zu einem Vorsehen von mehreren Teil-Kühlkörpern kann für die Kühlkörpereinrichtung ein sehr langer, insbesondere ein einziger, durchgehender Kühlkörper vorgesehen sein. In diesem Kühlkörper ist mindestens eine von außen hineinreichende Ausnehmung vorgesehen, die zwischen 10% und 30% des Querschnitts der Kühlkörpereinrichtung einnehmen kann. Vorteilhaft ist eine solche Ausnehmung an derjenigen Seite der Kühlkörpereinrichtung bzw. des Kühlkörpers vorgesehen, die zu dem Bauteilträger hin weist bzw. in der der Kühlkörper eine vorgenannte massive Basis oder einen massiven Basiskörper aufweist, wobei dann von dieser Basis oder von diesem Basiskörper übliche Rippen abstehen. Somit kann in einer solchen quasi in dem Kühlkörper durch ein materialabtragendes Verfahren erzeugten Ausnehmung ebenfalls eine Unterbrechung des Kühlkörpers vorgesehen sein entsprechend einem vorgenannten Zwischenbereich. In diesem kann Kühlluft ausgeleitet werden in Richtung auf den Bauteilträger bzw. auf dort vorhandene Bauteile, die auch noch gekühlt werden sollen, ohne dass ein allzu komplizierter Verlauf des Luftkanals oder ein weiterer Lüfter notwendig wären.

Um ein solches Ausleiten von Luft aus der Kühlkörpereinrichtung, also aus einem Zwischenbereich zwischen zwei Teil-Kühlkörpern oder aus einer Ausnehmung in einem einzigen Kühlkörper, zu verstärken können Luftausleitmittel vorgesehen sein. Diese können also ein gezieltes Ausleiten von Luft bewirken. Es ist möglich, dass solche Luftausleitmittel nach Art einer Klappe oder nach Art einer Luftleitschaufel ausgebildet sind, vorzugsweise mit einer Geometrie ähnlich einem aerodynamischen Tragflügel. Sie greifen in den Querschnitt des Luftkanals innerhalb der Kühlkörpereinrichtung ein, in der Regel also zwischen den Bereich der Rippen der Kühlkörpereinrichtung. So können sie einen Teil der entlangströmenden Luft herausleiten. Dabei können sie die Luft in Richtung auf weitere zu kühlende Bereiche und/oder Bauteile am Bauteilträger herausleiten. Sie können dann entweder direkt länglich ausgebildet sein zur besseren Luftleitung oder weitere Luftleitkanäle aufweisen bzw. bilden. Je nachdem, wie weit diese Luftausleitmittel in den Luftkanal eingreifen, leiten sie mehr oder weniger Luft aus der Kühlkörpereinrichtung heraus. Ein großer Teil der Wirkung der beschriebenen Anordnung besteht darin, dass warme Luft von einer Basis oder einem massiven Abschnitt der Kühlkörpereinrichtung weggeführt wird, somit also zunächst weniger erwärmte Luft von nachfolgenden Teil-Kühlkörpern weggeleitet werden kann. Ein zusätzlicher Effekt entsteht dadurch, dass hinter jedem Luftausleitmittel ein Unterdruck entsteht, was wiederum aus dem Freibereich bzw. aus dem Luftkanal kühlere Luft anzieht, aber auch zu einer Verwirbelung führt und deshalb für einen verbesserten Wärmeaustausch sorgt.

In vorteilhafter Weiterbildung der Erfindung kann vorgesehen sein, dass die Luftausleitmittel beweglich bzw. verstellbar ausgebildet sind dahingehend bezüglich des Maßes, in dem sie in den Querschnitt des Luftkanals innerhalb der Kühlkörpereinrichtung eingreifen. Somit kann also beeinflusst werden, wie viel Luft sie ausleiten. Für eine Beweglichkeit oder eine Verstellbarkeit der Luftausleitmittel gibt es eine Vielzahl von Möglichkeiten. Nach einer einfachen Möglichkeit können sie thermisch auslösbar und selbsttätig verstellbar ausgebildet sein. Dies erfolgt möglicherweise automatisch, wenngleich nicht gesteuert. Hierfür können die Luftausleitmittel bevorzugt aus Bimetall bestehen oder Bimetall aufweisen. Temperaturabhängig können sie also ihre Form ändern und somit mehr oder weniger weit in den Luftkanal eingreifen. Dabei können sie vor allem von denjenigen Bereichen oder Bauteilen am Bauteilträger thermisch beeinflusst werden, die sie dann auch durch auf sie geleitete Luft kühlen sollen. Dies ist eine sehr einfache Möglichkeit, die keinen Steuerungs- bzw. Regelungsaufwand benötigt und auch keine angesteuerten Aktoren. Derartige Luftausleitmittel können also langgestreckte Zungen sein.

Gemäß einer anderen Möglichkeit können die Luftausleitmittel einen Aktor aufweisen, mit dem sie verstellt werden können. Dies kann vorteilhaft ein elektromagnetischer oder ein elektromotorischer Aktor sein, wodurch eine einfache Ausgestaltung und gleichzeitig eine gute Steuerung bzw. Beeinflussung möglich sind. Diese Aktoren können sozusagen ausgelöst werden von einer Temperaturerfassung an den weiteren zu kühlenden Bereichen oder Bauteilen.

In ähnlicher Form wie für die Luftausleitmittel zuvor beschrieben kann, jedoch völlig unabhängig davon, an einem Außenbereich der Kühlkörpereinrichtung, also vorteilhaft hin zu einer der äußeren Wandungen, eine verstellbare Lufteinleitvorrichtung vorgesehen sein. Diese kann insbesondere nach Art einer Luftleitschaufel ausgebildet sein oder derartige Luftleitschaufeln aufweisen. Sie kann vorteilhaft demjenigen Bereich der Kühlkörpereinrichtung gegenüberliegen, an dem die zu kühlenden Bauteile anliegen, insbesondere also einer vorgenannten Basis bzw. eines Basiskörpers. Eine solche Lufteinleitvorrichtung kann dazu dienen, einen Freibereich des Luftleitkanals außerhalb der Kühlkörpereinrichtung zu verändern bzw. zu verringern. So kann eine Lufteinleitvorrichtung bewegbar sein zwischen zwei Positionen. In einer ersten Position ragt die Lufteinleitvorrichtung in den Freibereich und auch in die Kühlkörpereinrichtung hinein oder an diese heran. So kann Luft, die außerhalb der Kühlkörpereinrichtung entlang des Luftkanals strömt, in die Kühlkörpereinrichtung umgeleitet werden. Dies ist dann die vorgenannte Verringerung oder Beseitigung des Freibereichs. In einer zweiten Position kann die Lufteinleitvorrichtung weniger weit oder gar nicht in den Freibereich reichen oder an die Kühlkörpereinrichtung reichen, so dass sie dann nur wenig oder gar keine Luft in die Kühlkörpereinrichtung zusätzlich einleitet. Die erste Position und die zweite Position können vorteilhaft jeweils Endpositionen eines Bewegungswegs der Lufteinleitvorrichtung sein. Für eine solche Bewegung kann die Lufteinleitvorrichtung verschiedenartig ausgebildet sein. Gemäß einer Möglichkeit kann sie thermisch auslösbar und temperaturabhängig selbsttätig verstellbar ausgebildet sein, wie es zuvor beschrieben worden ist. Hierfür kann ein bimetallischer Aktor verwendet werden, der Bimetall aufweisen kann oder aus Bimetall bestehen kann. Dabei kann die Lufteinleitvorrichtung oder eine diese im Wesentlichen bildende Luftleitschaufel auch selbst weitgehend bimetallisch ausgebildet sein oder Bimetall aufweisen. Ein bimetallischer Aktor kann auch aus einem Bimetall und einem zusätzlichen Heizelement bestehen, falls die Erwärmung durch Kühlkörpereinrichtung selbst nicht ausreicht für eine ausreichende Auslenkung des Bimetalls. Das Bimetall kann also durch die zusätzliche Beheizung stärker ausgelenkt werden. Vorteilhaft können hierfür keramische Heizelemente verwendet werden, besonders vorteilhaft mit einem Dickschichtheizelement auf einem flachen keramischen Träger.

In alternativer Ausgestaltung der Erfindung kann wiederum ein vorgenannter elektromagnetischer oder elektromotorischer Aktor vorgesehen sein, der dann direkt angesteuert und zusätzlich mit elektrischer Energie versorgt werden muss. Er kann mittels vorgesehener Temperatursensoren angesteuert werden, alternativ kann eine Ansteuerung für den Aktor auf andere Weise eine Information zur verstärkten Lufteinleitung erhalten.

In vorteilhafter Ausgestaltung der Erfindung können die Außenwandung und vorzugsweise auch das genannte Gehäuseteil unter der Kühlkörpereinrichtung jeweils von einem Wandungsbereich eines Gehäuses für das Leistungsteil gebildet sein. In diesem Gehäuse kann das Leistungsteil dann angeordnet sein, möglicherweise auch noch weitere Einrichtungen des Elektrogeräts, für welches das Leistungsteil vorgesehen ist. Ist das Leistungsteil Bestandteil eines eingangs genannten, erfindungsgemäßen Induktionskochfelds, so kann das Leistungsteil vorteilhaft an einem äußeren Randbereich des Gehäuses verlaufen. So kann es vorteilhaft an dem Induktionskochfeld, insbesondere unter einer Kochfeldplatte davon, angeordnet sein, wie dies an sich grundsätzlich bekannt ist. Auf dem Gehäuse kann dann eine Abdeckung odgl. vorgesehen sein, welche wie zuvor beschrieben eine dritte äußere Wandung bildet, die den Luftkanal sozusagen nach oben begrenzt.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Weitere Vorteile und Aspekte der Erfindung ergeben sich aus den Ansprüchen und aus der Beschreibung von Ausführungsbeispielen der Erfindung, die nachfolgend anhand der Figuren erläutert sind. Dabei zeigen:
- Fig. 1: eine vereinfachte seitliche Schnittdarstellung durch ein erfindungsgemäßes Induktionskochfeld mit einem erfindungsgemäßen Leistungsteil,
- Fig. 2: eine Draufsicht auf das erfindungsgemäße Leistungsteil aus Fig. 1 mit Bauteilträger, Kühlkörpern, Lüfter und Luftkanal,
- Fig. 3: eine Schnittdarstellung durch das Leistungsteil aus Fig. 2 im vorderen Bereich des Luftkanals,
- Fig. 4: eine Schnittdarstellung ähnlich Fig. 3 im ganz hinteren Bereich des Luftkanals,
- Fig. 5: eine vergrößerte Darstellung einer Draufsicht auf das Leistungsteil aus Fig. 2 mit einer Darstellung einer zusätzlichen Luftausleitklappe zwischen zwei Kühlkörpern in einer Inaktiv-Position,
- Fig. 6: eine Darstellung entsprechend Fig. 5 mit der Luftausleitklappe in einer Aktiv-Position,
- Fig. 7: eine Darstellung eines abgewandelten Leistungsteils ähnlich Fig. 2 mit anders ausgebildetem Luftkanal und Lufteinleitklappen zwischen den Kühlkörpern und dem Luftkanal und
- Fig. 8: eine nochmals weitere Abwandlung eines Leistungsteils ähnlich Fig. 2 mit einem Luftkanal ähnlich Fig. 7 und nach hinten versetzten Kühlkörpern.

### Detaillierte Beschreibung der Ausführungsbeispiele

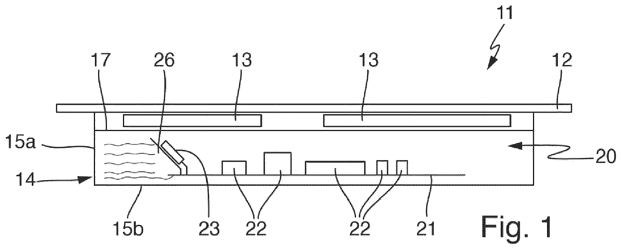

In der Fig. 1 ist ein erfindungsgemäßes Induktionskochfeld 11 im Schnitt darstellt. Das Induktionskochfeld 11 weist eine übliche Kochfeldplatte 12 auf. An dessen Unterseite sind Induktionsheizspulen 13 angedrückt. Die wesentlichen funktionalen Baueinheiten des Induktionskochfelds 11 sind in einem Gehäuse 14 mit Gehäuseaußenwand 15a und Gehäuseboden 15b angeordnet. Das Gehäuse 14 kann vorteilhaft aus Kunststoff bestehen und so sehr frei und vielfältig ausgebildet sein. Das Gehäuse 14 ist nach oben mit einer Abdeckung 17 versehen, auf welcher die Induktionsheizspulen 13 aufgelegt sein können.

In dem Gehäuse 14 ist ein erfindungsgemäßes Leistungsteil 20 angeordnet. Das Leistungsteil 20 weist einen flächigen Bauteilträger 21 auf, insbesondere eine Platine, auf der zum einen verschiedenartige Bauteile 22 angeordnet sind. Vor allem sind im linken Bereich des Bauteilträgers 21 IGBT 23 bzw. Gleichrichter 23` angeordnet. Diese sind die eingangs genannten Leistungshalbleiter und werden im Betrieb der Induktionsheizspulen 13 warm bzw. heiß. Deswegen werden sie auf an sich bekannte Art und Weise gekühlt, indem sie an Kühlkörpern 26 anliegen. Diese Kühlkörper 26 werden nachträglich noch im Detail erläutert. Die Kühlkörper 26 wiederum werden durch Luft entlang eines in Fig. 1 links verlaufenden Luftkanals 33 gekühlt, wie nachfolgend dargestellt wird.

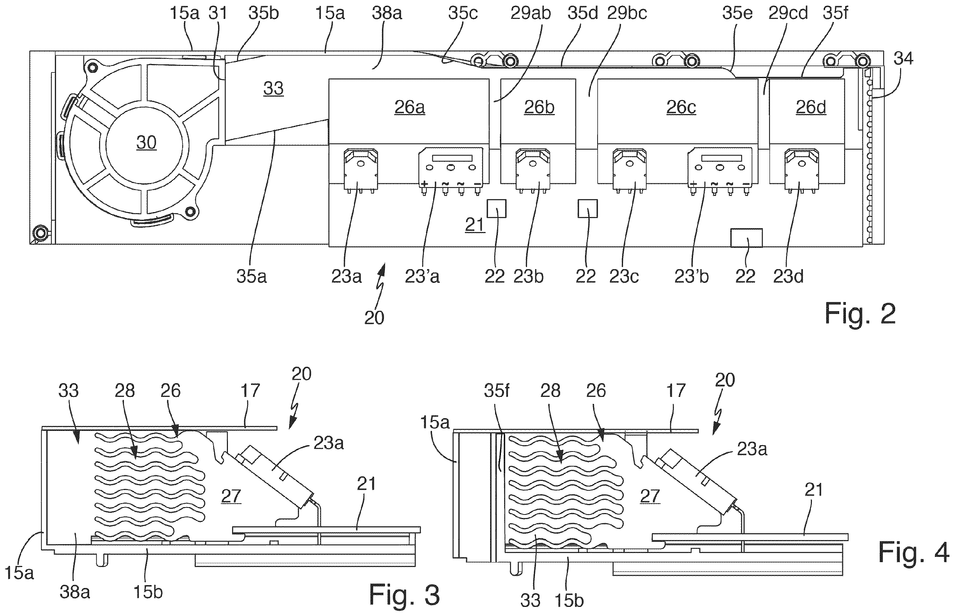

In Fig. 2 ist eine Draufsicht auf ein erfindungsgemäßes Leistungsteil 20 in dem Gehäuse 14 dargestellt. Das Leistungsteil 20 ist entsprechend Fig. 1 nahe an der Gehäuseaußenwand 15a angeordnet. Es ist der eine Teil des Bauteilträgers 21 gut zu erkennen, auf dem vier IGBT 23a, 23b, 23c und 23d angeordnet sind. Sie sind in einer Linie angeordnet. Rechts neben den IGBT 23a und 23c ist jeweils ein Gleichrichter 23'a und 23'b angeordnet. Für jeden der IGBT 23a bis 23d ist ein eigener Kühlkörper 26a bis 26d vorgesehen. Die Kühlkörper 26a und 26c mit den Gleichrichtern 23'a und 23'b rechts neben den IGBT 23a und 23c sind länger ausgeführt für mehr Kühlleistung bzw. stärkere Kühlung.

Des Weiteren sind auf dem Bauteilträger 21 einige der zuvor genannten weiteren Bauteile 22 angeordnet. Diese sollen nach Möglichkeit auch noch gekühlt werden später noch, wie nachfolgend erläutert wird. Zwischen den Kühlkörpern 26a bis 26d befinden sich unterschiedlich große Abstände 29ab, 29bc und 29cd. Diese dienen zur vereinfachten Einleitung von kühlender Luft, wie nachfolgend noch näher erläutert wird.

Am hinteren Bereich der Kühlkörper 26a bis 26d zur Gehäuseaußenwand 15a verläuft ein Luftkanal 33, der sozusagen links beginnt, wobei hier ein an sich bekannter radial arbeitender Lüfter 30 mit einem Lüfterauslass 31 angeordnet ist. Der Lüfterauslass 31 weist genau in Richtung des Luftkanals 33 bzw. in Richtung der Kühlkörper 26a bis 26d. Nach rechts weist der Luftkanal 33 einen Auslass 34 aus dem Gehäuse 14 auf, vorteilhaft versehen mit einem Gitter, wie es an sich üblich ist. Links am Beginn des Luftkanals 33 ist direkt an den unteren Teil des Lüfterauslasses 31 anschließend eine Luftleitschaufel 35 vorgesehen. Demgegenüber ist eine kurze Luftleitschaufel 35b vorgesehen. Dann trifft die im Luftkanal 33 entlangströmende Luft auf den linken Bereich des ersten Kühlkörpers 26a. Nach hinten wird der Luftkanal 33 gebildet von der Gehäuseaußenwand 15a. Diese Gehäuseaußenwand 15a weist in der Praxis einen Abstand von 7 mm bis 20 mm zum Kühlkörper 26a auf, wodurch ein zuvor erläuterter Freibereich 38a gebildet ist. Ab etwa der Mitte und gegenüberliegend dem hinteren Bereich des Kühlkörpers 26a ist eine weitere Luftleitschaufel 35c angeordnet, die sich von der inneren Seite der Gehäuseaußenwand 15a nach innen erstreckt und den Luftkanal 33 sozusagen verengt. Diese Verengung endet kurz vor dem Abstand 29ab zwischen den Kühlkörpern 26a und 26b, und ab dieser Luftleitschaufel 35c bzw. ab der dadurch gebildeten Verengung ist ein folgender Freibereich 38b deutlich kleiner als der Freibereich 38a. Er kann noch etwa 0,5 cm bis 1 cm betragen. Hier wird der Luftkanal 33 nach hinten begrenzt durch eine Luftleitschaufel 35d, welche parallel zur hinteren Seite der Kühlkörper 26b und 26c mit gleichbleibendem Abstand dazu verläuft. Somit ist hinter dem Kühlkörper 26c ein Freibereich 38c ähnlich wie der Freibereich 38b vorgesehen. Dann kommt entweder eine weitere Luftleitschaufel 35e oder die vorhandene Luftleitschaufel ist noch einmal gebogen, so dass sich der Luftkanal 33 erneut stark verengt, wodurch auch der Freibereich 38c kleiner wird bzw. sozusagen verschwindet. Dann wird die hintere Wandung des Luftkanals 33 von einer Luftleitschaufel 35f gebildet, welche ganz knapp hinter dem hintersten Kühlkörper 26d verläuft, so dass hier eigentlich kein Freibereich mehr gegeben ist. Danach geht der Luftkanal 33 sozusagen zu dem Auslass 34 hin.

Noch besser nachvollziehen lässt sich der Verlauf des Luftkanals 33 bzw. die Breite der Freibereiche aus den Fig. 3 und 4 mit der jeweiligen Schnittdarstellung. Die Fig. 3 zeigt einen Schnitt durch den ganz linken bzw. ersten IGBT 23a. Er liegt schräggestellt an dem Kühlkörper 26 an, und zwar an einer massiven Basis 27 davon. Von dieser Basis 27 erstrecken sich Rippen 28 nach links, die gewellt ausgebildet sind zur Vergrößerung ihrer Oberfläche für besseren Wärmeaustausch und somit für eine bessere Kühlwirkung des IGBT 23a. Der Kühlkörper 26 ist vorteilhaft aus Aluminium ausgebildet, besonders vorteilhaft hergestellt im Strangpressverfahren. Aus einem langen Profil können dann die einzelnen Kühlkörper 26a bis 26d entsprechend der Fig. 2 abgelängt bzw. abgesägt werden je nach Bedarf. Der Kühlkörper 26 ist auch von links auf eine Außenkante des Bauteilträgers 21 sozusagen aufgesteckt und kann durch Verschrauben oder sonstige Befestigungsmöglichkeiten damit fest verbunden sein. Der Kühlkörper 26 verläuft auch mit geringem Abstand unterhalb der Abdeckung 17 und oberhalb des Gehäusebodens 15b. In der Fig. 3 nach links, was in der Fig. 2 nach hinten entspricht, ist ein Abstand der Enden der Rippen 28 und somit des Kühlkörpers 26 zu der Gehäuseaußenwand 15a gegeben, und dieser Abstand entspricht dem Freibereich 38a und bildet einen Teil des Luftkanals 33. Die größere Breite des Luftkanals 33 erstreckt sich durch die einzelnen Rippen 28.

In der Fig. 4 ist eine entsprechende Schnittdarstellung durch den IGBT 23d ganz rechts bzw. hinten dargestellt. Es ist zu erkennen, dass der Kühlkörper 26d denselben Querschnitt aufweist wie der Kühlkörper 26a aus Fig. 3. Auch die Gehäuseaußenwand 15a ist noch dieselbe, hier ist lediglich die zuvor erläuterte Luftleitschaufel 35f vorhanden, welches mit sehr geringem Abstand zu den Rippen 28 bzw. ihren Enden verläuft. Somit ist hier kein Freibereich mehr gegeben, der Luftkanal 33 ist schmaler und verläuft nur noch durch die Rippen 28.

Wie aus der Gesamtschau der Fig. 2 bis 4 gut zu erkennen ist, wird ein Teil der vom Lüfter 30 in den Luftkanal 33 ganz am Anfang eingebrachten Luft stets durch die Rippen 28 der Kühlkörper 26a bis 26d strömen und diese kühlen. Ein nennenswerter Anteil der Luft wird aber auch entlang der Freibereiche 38a, 38b und 38c strömen, und zwar an den Kühlkörpern 26a bis 26c vorbei. Diese Luft ist dann noch kühl. Durch die erste Verengung an der Luftleitschaufel 35c mit verringertem Freibereich 38b wird ein Teil dieser Luft zusätzlich in den Kühlkörper 26b gelenkt bzw. gedrückt und kann diesen noch besser kühlen, da diese Luft ja noch kühl ist. Im verringerten Freibereich 38b und 38c kann ein immer noch nennenswerter Teil der Luft an den Kühlkörpern 26b und 26c vorbeiströmen und kühl bleiben. An der durch dieLuftleitschaufel 35e gebildeten weiteren Verengung des Luftkanals 33, wodurch der Freibereich 38c verschwindet, wird auch diese Luft sozusagen in die Kühlkörper hineingelenkt, nämlich in das Ende des Kühlkörpers 26c und vor allem zusätzlich in den Kühlkörper 26d. Somit kann auch dieser zusätzlich noch gekühlt werden, da an sich dessen Kühlwirkung geringer ist. Die durch die Rippen 28 strömende Luft innerhalb des Luftkanals 33 ist nämlich schon von den drei Kühlkörpern 26a bis 26c davor aufgewärmt worden, ihre Kühlwirkung ist also erheblich geringer.

Durch die Abstände 29ab, 29bc und 29cd kann die Luft von oben sehr gut zusätzlich in die Kühlkörper bzw. in deren Rippen 28 eingeleitet werden. Des Weiteren können so die entsprechenden Leistungshalbleiter wärmetechnisch besser entkoppelt werden.

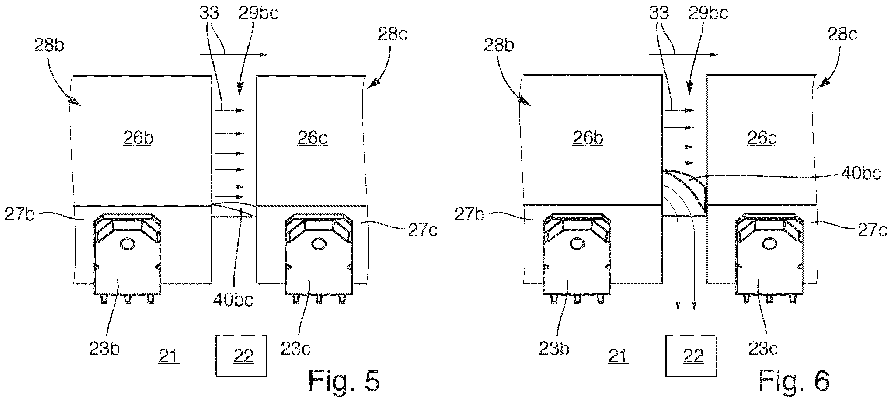

In den Fig. 5 und 6 ist eine Möglichkeit gezeigt, wie aufgrund eines Abstands 29bc zwischen den Kühlkörpern 26b und 26c Luft ausgeleitet werden kann, um zu einem ebenfalls zu kühlenden Bauteil 22 auf dem Bauteilträger 21 geleitet zu werden. Dazu ist eine aus Bimetall ausgebildete Luftausleitklappe 40bc mit ihrem rechten Ende fest gelagert, entweder am Bauteilträger 21 oder vorteilhaft an der linke Seite des Kühlkörpers 26c. Diese Luftausleitklappe 40 kann sich auf die Fig. 3 und 4 bezogen über einen Teil der Höhe zwischen Bauteilträger 21 bzw. Gehäuseboden 15b und Abdeckung 17 erstrecken, möglicherweise auch über die gesamte Höhe. Die Luftausleitklappe 40 aus Bimetall kann so ausgebildet sein, dass der Bereich mit höherer Ausdehnung zum Bauteil 22 hin weist und auf der anderen Seite der Bereich mit geringerer Wärmeausdehnung vorhanden ist. In der Fig. 5 ist eine Position bzw. Stellung der Luftausleitklappe 40 bei geringer Temperatur dargestellt, in der sogenannten Inaktiv-Position. Sie befindet sich im Wesentlichen zwischen den beiden Basen 27 der Kühlkörper 26b und 26c. Dadurch leitet sie keine Luft aus dem hier vorhandenen Luftkanal 33 im Abstand 29bc, deswegen ist sie ja sozusagen inaktiv.

Wird die gesamte Einrichtung wärmer, insbesondere natürlich die Kühlkörper 26b und 26c, wodurch in der Regel auch das Bauteil 22 stärker gekühlt werden sollte, so verbiegt sich bzw. verformt sich die Luftausleitklappe 40 und dreht sich sozusagen etwas um ihren Befestigungspunkt im Uhrzeigersinn. Dadurch ragt sie in dieser sogenannten Aktiv-Position stärker in den Luftkanal 33 und vor allem vor die Rippen 28 des rechten Kühlkörpers 26c. Damit kann sie einen durch die Pfeile dargestellten Teil der Kühlluft ausleiten, zwischen den Basen 27 der beiden Kühlkörper 26b und 26c hindurch auf das Bauteil 22. Somit kann dieses auch etwas gekühlt werden. Derartige Luftausleitmittel in Form einer aus Bimetall ausgebildeten Luftausleitklappe 40 weisen natürlich den großen Vorteil auf, dass sie keine zusätzlichen Aktoren wie die eingangs genannten Elektromotoren oder Elektromagnete benötigen. Durch ihre Ausgestaltung kann ihre Temperaturabhängigkeit und ihre Wirkung sehr gut eingestellt werden.

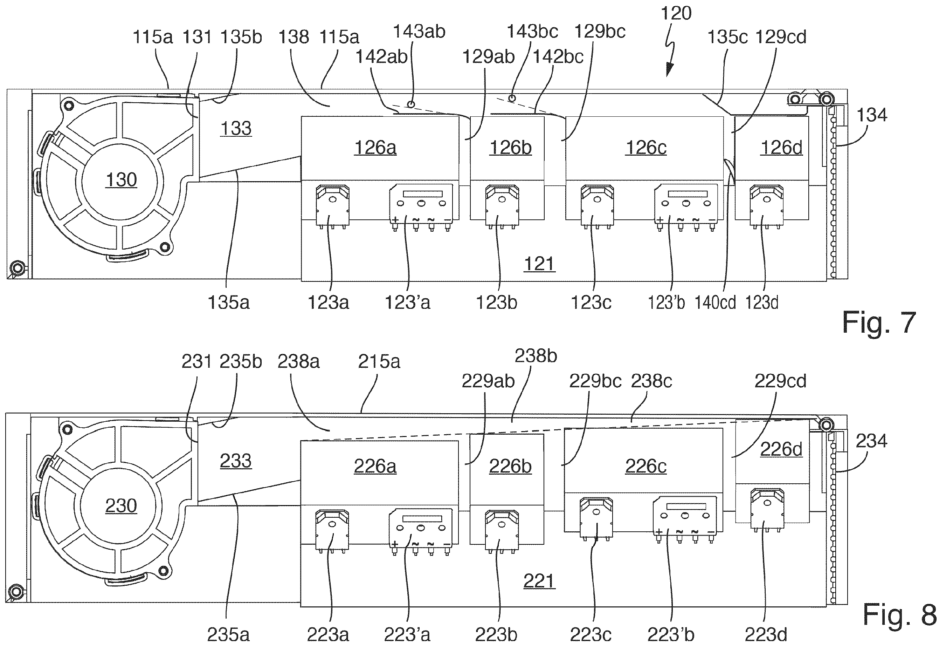

In der Fig. 7 ist eine Abwandlung eines Leistungsteils 120 dargestellt, wobei dieses Leistungsteil 120 dem Leistungsteil 20 aus Fig. 2 offensichtlich sehr ähnelt. Ein erster wesentlicher Unterschied besteht darin, dass die obere Wandung des Luftkanals 133 hinter der Luftleitschaufel 135b über einen sehr langen Bereich nur von der Außenwandung 115a gebildet ist, nämlich bis in den Bereich etwa mittig über dem dritten Kühlkörper 126c. Erst hier ist wieder eine Luftleitschaufel 135c vorgesehen, welches den Luftkanal 133 durch Reduzierung des Freibereichs 138 verengt. Dabei führt, ähnlich wie in Fig. 2 bei der Luftleitschaufel 35e, die Luftleitschaufel 135c bis an die hintere Seite des vierten Kühlkörpers 126d. So wird also spätestens hier die gesamte Luft, die im Luftkanal 133 außerhalb der Kühlkörper 136 entlang strömt, in diesem letzten Kühlkörper 136d eingeleitet.

Um nun aber auch weiterhin für die Kühlkörper 126b und 126c zusätzliche Luft zur Kühlung bereitzustellen, sind zwei Lufteinleitklappen 142ab 142bc vorgesehen. Sie können im Prinzip ähnlich ausgebildet sein wie die Luftausleitklappen 40 der Fig. 5 und 6. Des Weiteren können sie auch so ausgebildet sein, dass sie am rechten Ende befestigt sind und sich bei zunehmender Temperatur nach rechts bzw. sozusagen im Uhrzeigersinn drehen. Wenn sie dabei thermisch mit dem jeweils zugehörigen Kühlkörper verbunden sind, auf den sie im nach rechts verdrehten Zustand Luft leiten können, dann können sie sozusagen von dessen Temperatur beeinflusst, also bedarfsgemäß, Luft einleiten. Dazu kann die Lufteinleitklappe 142ab sozusagen thermisch mit dem Kühlkörper 126b gekoppelt sein, insbesondere daran befestigt sein. Erwärmt sich dieser stark, so verdreht sich die Lufteinleitklappe 142ab in die in Fig. 7 dargestellte Position. Hier ist ein Anschlag 143ab vorgesehen, der ein noch weiteres Verdrehen verhindert. Ansonsten könnte es nämlich sein, dass die Lufteinleitklappe 142ab sehr weit in den Luftkanal 133 hineinreicht bzw. bis an die Gehäuseaußenwand 115a anliegt und somit das Weiterleiten von Luft entlang des Freibereichs 138 beeinträchtigt. Somit stellt auch die Lufteinleitklappe 142ab eine Verengung des Freibereichs dar, was der Kern der Erfindung ist, wenngleich diese Verengung nur bereichsweise ist.

Die zweite Lufteinleitklappe 142bc kann genauso ausgebildet sein und an dem dritten Kühlkörper 126c angebracht sein sowie thermisch mit diesem gekoppelt sein. Auch sie weist einen Anschlag 143bc auf, der etwas näher an der Gehäuseaußenwand 115 angeordnet ist als der Anschlag 143ab. Durch diesen Anschlag 143bc kann immer noch Luft in dem Freibereich 138 entlangströmen und dann ganz hinten aufgrund der Luftleitschaufel 135c in den vierten Kühlkörper 126d eingeleitet werden. Hinter der Luftleitschaufel 135c besteht der Freibereich 138 gar nicht mehr. Die Wirkung der Luftleitschaufel 135c bzw. des Einleitens von kühler Luft aus dem Freibereich 138 in den vierten Kühlkörper 126d kann noch unterstützt werden durch eine Luftausleitklappe 140cd zwischen dem dritten Kühlkörper 126c und dem vierten Kühlkörper 126d, und zwar mit einer Funktion wie zu Fig. 6 beschrieben.

In der Fig. 8 ist eine nochmals weitere alternative Ausbildung eines erfindungsgemäßen Leistungsteils 220 dargestellt. Hier verläuft der Luftkanal 233 prinzipiell ähnlich wie in Fig. 7, nämlich am Anfang mit einer Luftleitschaufel 235a unten und 235b oben. Dann wird der Luftkanal 233 nach hinten aber ausschließlich von der Gehäuseaußenwand 215a gebildet, ist also gerade. Erst ganz hinten ist eine dritte Luftleitschaufel 235c vorgesehen, welches die Luft zu dem gitterartigen Auslass 234 lenkt.

Eine von links nach rechts zunehmende Verengung des Freibereichs 238 erfolgt hier dadurch, dass die Kühlkörper 226a bis 226d eine größere Erstreckung nach hinten aufweisen. Beispielhaft ist dies für den Kühlkörper 226b im Vergleich zu dem Kühlkörper 226a dargestellt, er reicht einige Millimeter weiter nach hinten. Da er vorne sozusagen an derselben Stelle beginnt, ist der Kühlkörper 226b insgesamt länger in Richtung zur Gehäuseaußenwand 215a, kann also längere Rippen aufweisen. Dies könnte jeweils für die Kühlkörper 226c und 226d auf dieselbe Art und Weise auch erfolgen, sie können jeweils stufenweise längere Rippen aufweisen. Die langen Rippen des ganz rechten Kühlkörpers 226d liegen dann sozusagen an der Gehäuseaußenwand 215a an.

Alternativ können die Kühlkörper, wie für die Kühlkörper 226c und 226d dargestellt ist, denselben Querschnitt aufweisen, sie sind aber samt ihrer IGBT und Gleichrichter auf dem Bauteilträger 221 nach hinten versetzt. Bei einer derartigen Ausgestaltung könnten also alle vier Kühlkörper 226a bis 226d identischen Querschnitt aufweisen, also aus einem Strangprofil abgesägt sein wie eingangs erläutert worden ist. Sie sind dann nur jeweils stufig nach hinten versetzt, um den zu Beginn noch großen Freibereich 238 im Luftkanal 233 zu verringern. Auch so kann zusätzliche Luft in die stufig nach hinten versetzten Kühlkörper 226 eingeleitet werden.

Eine nochmals weitere alternative Ausgestaltung, die leicht vorstellbar ist, ist mit der gestrichelten Kontur der Kühlkörper 226 nahe bei der Gehäuseaußenwand 215a dargestellt. Hier können die Kühlkörper 226 sozusagen schräg nach hinten verlaufen. Ihre hinteren Kanten, die zu der Gehäuseaußenwand 215a weisen, verlaufen also nicht mehr parallel dazu, sondern mit einem geringen Winkel von 3° bis 7° leicht schräg dazu. Entsprechend dieser gestrichelten schrägen Linie sind dann auch die Kühlkörper 226 schräg an dem Bauteilträger 221 angebracht. Sie bewirken also sozusagen eine kontinuierliche Verringerung des Freibereichs 238 entlang des Luftkanals 233 weg vom Lüfter 230. Dies kann beispielsweise leicht dadurch erreicht werden, dass eine Seite bzw. Kante des Bauteilträgers 221, die gemäß der Fig. 3 und 4 in eine Ausnehmung unten an der Basis 27 des Kühlkörper 26 eingreift, entsprechend schräg ausgebildet ist. Auch diese alternative Ausgestaltung weist den Vorteil auf, dass sozusagen identische Kühlkörper verwendet werden können bzw. Kühlkörper aus demselben Profil.

In einer nochmaligen weiteren Ausgestaltung der Erfindung, die hier nicht dargestellt ist, wird der vierte Kühlkörper ganz am Ende bzw. maximal weit entfernt von dem Lüfter nicht benötigt, ist also nicht vorhanden. Somit wird hier auch der gesamte Luftkanal bzw. Freibereich nicht benötigt, die gesamte Luft, die vom Lüfter kommt, soll also von Beginn an in die Kühlkörpereinrichtung hineinströmen. Dann kann der Luftkanal sozusagen verschlossen werden, beispielsweise indem eine weitere Luftleitschaufel ähnlich der Luftleitschaufel 35b aus Fig. 2 links am ersten Kühlkörper 26a vorgesehen ist. Alternativ kann die Luftleitschaufel 35b selbst vom Lüfter 30 bis zur Ecke links oben am ersten Kühlkörper 26a führen. In vorteilhafter Weiterbildung können auch die drei Kühlkörper 26a bis 26c am hinteren Ende verschlossen sein, damit hier keine Kühlluft austritt. Dies kann durch eine stark verlängerte Luftleitschaufel 35b erreicht werden, die dann vom Lüfter 30 bis zum rechten Ende des dritten Kühlkörpers 26c reicht. Sie liegt hinten an den Kühlkörpern 26a bis 26c an wie die Luftleitschaufel 35f am Kühlkörper 26d der Fig. 2.

## Patentansprüche

1. Leistungsteil, insbesondere für ein Elektrogerät wie ein Induktionskochfeld, wobei das Leistungsteil aufweist:
- einen Bauteilträger, auf dem zu kühlende Bauteile, insbesondere Leistungshalbleiter, angeordnet sind,
- eine Kühlkörpereinrichtung, an der die zu kühlenden Bauteile zur Wärmeübertragung anliegen,
- einen Lüfter mit einem Lüfterauslass, der in Richtung zu der Kühlkörpereinrichtung gerichtet ist,
- einen Luftkanal von dem Lüfter bzw. von dessen Lüfterauslass zu der Kühlkörpereinrichtung,
wobei:
+ die Kühlkörpereinrichtung länglich ist, insbesondere entlang einer Linie, die zu dem Lüfter bzw. dem Lüfterauslass weist,
+ der Luftkanal teilweise durch die Kühlkörpereinrichtung begrenzt ist,
+ der Luftkanal zwei oder drei äußere Wandungen aufweist, die aneinander angrenzen und winklig zueinander angeordnet sind,
+ sich der Luftkanal entlang dieser zwei oder drei äußeren Wandungen an der Kühlkörpereinrichtung entlang erstreckt,
**dadurch gekennzeichnet, dass**:
- der Luftkanal im Wesentlichen von den zwei oder drei äußeren Wandungen und von der Kühlkörpereinrichtung gebildet bzw. begrenzt ist,
- der Luftkanal an einem Anfangsbereich der Kühlkörpereinrichtung einen Freibereich außerhalb der Kühlkörpereinrichtung und zwischen den äußeren Wandungen bzw. zu den äußeren Wandungen hin aufweist, wobei dieser Freibereich in Längsrichtung des Luftkanals weg von dem Lüfter hin zu einem Ende des Luftkanals kleiner wird.

2. Leistungsteil nach Anspruch 1, **dadurch gekennzeichnet, dass** der Luftkanal gebildet ist von der Kühlkörpereinrichtung, von einem Gehäuseteil unter der Kühlkörpereinrichtung und von einer Außenwandung, die senkrecht bzw. winklig zu dem Gehäuseteil steht und zumindest teilweise den Freibereich zu der Kühlkörpereinrichtung aufweist, wobei vorzugsweise der Luftkanal nach oben geschlossen ist durch eine Abdeckung über der Kühlkörpereinrichtung.

3. Leistungsteil nach Anspruch 1 oder 2, **dadurch gekennzeichnet, dass** die Kühlkörpereinrichtung selbst entlang des Luftkanals keine Querschnittsänderung aufweist bzw. denselben Querschnitt behält, insbesondere keine Variation des Querschnitts aufweist, wobei sich der Querschnitt des Luftkanals durch Änderung des Verlaufs mindestens einer der äußeren Wandungen entlang des Luftkanals verengt und der Freibereich enger wird bzw. kleiner wird, wobei vorzugsweise sich der Verlauf der mindestens einen äußeren Wandung ändert, wobei insbesondere zwei solche Querschnittsänderungen bzw. Verengungen des Freibereichs des Luftkanals vorgesehen sind, und wobei insbesondere der Luftkanal hinter der letzten Verengung zu mindestens 90% von dem Querschnitt der Kühlkörpereinrichtung eingenommen ist.

4. Leistungsteil nach Anspruch 3, **dadurch gekennzeichnet, dass** eine erste Verengung des Luftkanals nach 20% bis 45% der Länge des Luftkanals weg von dem Lüfter vorgesehen ist, wobei vorzugsweise eine letzte Verengung des Luftkanals nach 70% bis 90% der Länge des Luftkanals weg von dem Lüfter vorgesehen ist.

5. Leistungsteil nach Anspruch 3 oder 4, **dadurch gekennzeichnet, dass** jeweils eine Verengung des Luftkanals den Freibereich um 25% bis 50% reduziert.

6. Leistungsteil nach Anspruch 1 oder 2, **dadurch gekennzeichnet, dass** der Querschnitt des Luftkanals außerhalb der Kühlkörpereinrichtung gleich bleibt, wobei die Kühlkörpereinrichtung an einem zu dem Lüfter weisenden Anfangsbereich schmäler ausgebildet ist mit verringertem Querschnitt als weiter weg davon, insbesondere mit um 10% bis 50% verringertem Querschnitt, wobei vorzugsweise 10% bis 30% der Länge der Kühlkörpereinrichtung einen geringeren Querschnitt als am Anfangsbereich aufweisen, wobei vorzugsweise die Wandungen des Luftkanals außerhalb der Kühlkörpereinrichtung selbst gerade verlaufen,

7. Leistungsteil nach einem der vorhergehenden Ansprüche, **dadurch gekennzeichnet, dass** Einschnitte oder Unterbrechungen in der Kühlkörpereinrichtung in Richtung quer zur Längsrichtung des Kühlkörper vorgesehen sind ohne den Querschnitt zu ändern.

8. Leistungsteil nach einem der vorhergehenden Ansprüche, **dadurch gekennzeichnet, dass** die Kühlkörpereinrichtung mehrere Teil-Kühlkörper mit identischem Querschnitt aufweist, die hintereinander in der Längsrichtung des Luftkanals angeordnet sind, vorzugsweise genau in derselben Erstreckungsrichtung bzw. in genauer Überdeckung miteinander, wobei zwischen mindestens zwei Teil-Kühlkörpern, insbesondere zwischen allen Teil-Kühlkörpern, ein Abstand zur Bildung eines Zwischenbereichs vorgesehen ist, wobei der Zwischenbereich eine Länge zwischen 1% und 10% der Länge der gesamten Kühlkörpereinrichtung aufweist, wobei vorzugsweise zumindest zwei Teil-Kühlkörper eine unterschiedliche Länge entlang der Längsrichtung des Luftkanals aufweisen.

9. Leistungsteil nach einem der Ansprüche 1 bis 7, **dadurch gekennzeichnet, dass** die Kühlkörpereinrichtung einen einzigen durchgehenden Kühlkörper aufweist und in dem Kühlkörper mindestens eine von außen hineinreichende Ausnehmung vorgesehen ist, die zwischen 10% und 30% des Querschnitts der Kühlkörpereinrichtung einnimmt, wobei vorzugsweise die mindestens eine Ausnehmung an einer Seite der Kühlkörpereinrichtung zu dem Bauteilträger hin vorgesehen ist und/oder in einem Bereich der Kühlkörpereinrichtung vorgesehen ist, in der diese einen massiven Basiskörper aufweist, von dem aus Rippen abstehen.

10. Leistungsteil nach Anspruch 8 oder 9, **dadurch gekennzeichnet, dass** in dem Abstand bzw. in dem Zwischenbereich zwischen Teil-Kühlkörpern nach Anspruch 8 oder in einer Ausnehmung in dem einzigen Kühlkörper nach Anspruch 9 Luftausleitmittel vorgesehen sind, insbesondere Luftausleitmittel nach Art einer Klappe oder einer Luftleitschaufel, wobei die Luftausleitmittel in den Querschnitt des Luftkanals innerhalb der Kühlkörpereinrichtung eingreifen und einen Teil der entlangströmenden Luft aus der Kühlkörpereinrichtung herausleiten, insbesondere in Richtung auf zu kühlende Bereiche und/oder Bauteile am Bauteilträger herausleiten.

11. Leistungsteil nach Anspruch 10, **dadurch gekennzeichnet, dass** die Luftausleitmittel beweglich bzw. verstellbar ausgebildet sind bzgl. des Maßes, in dem sie in den Querschnitt des Luftkanals innerhalb der Kühlkörpereinrichtung eingreifen, insbesondere thermisch auslösbar selbsttätig verstellbar ausgebildet sind, wobei vorzugsweise die Luftausleitmittel aus Bimetall bestehen bzw. Bimetall aufweisen.

12. Leistungsteil nach einem der vorhergehenden Ansprüche, **dadurch gekennzeichnet, dass** an einem Außenbereich der Kühlkörpereinrichtung mit Luftwegen darin, der zu einer der äußeren Wandungen hin weist, eine Lufteinleitvorrichtung vorgesehen ist, insbesondere nach Art einer Luftleitschaufel, wobei vorzugsweise der Außenbereich mit der Lufteinleitvorrichtung den zu kühlenden Bauteilen gegenüberliegt.

13. Leistungsteil nach Anspruch 12, **dadurch gekennzeichnet, dass** die Lufteinleitvorrichtung bewegbar ist zwischen einer ersten Position, in der die Lufteinleitvorrichtung in den Freibereich ragt und Luft, die außerhalb der Kühlkörpereinrichtung entlang des Luftkanals strömt, in die Kühlkörpereinrichtung umleitet, und einer zweiten Position, in der die Lufteinleitvorrichtung weniger weit oder gar nicht in den Freibereich ragt.

14. Leistungsteil nach Anspruch 12 oder 13, **dadurch gekennzeichnet, dass** die Lufteinleitvorrichtung thermisch auslösbar und temperaturabhängig selbsttätig verstellbar ausgebildet ist, insbesondere mittels eines bimetallischen Aktors, wobei vorzugsweise der Aktor aus Bimetall besteht oder Bimetall aufweist.

15. Induktionskochfeld, **dadurch gekennzeichnet, dass** es ein Gehäuse mit Wandungen und ein Leistungsteil nach einem der vorhergehenden Ansprüche aufweist, wobei vorzugsweise das Leistungsteil an einem äußeren Randbereich des Gehäuses verläuft.
